# EUROPEAN PATENT APPLICATION

(11) **EP 1 873 880 A1**
(43) Date of publication of application: **02.01.2008**
(21) Application number: 06730796.7
(22) Date of filing: 31.03.2006
(51) Int. Cl.: H01S 5/343, H01L 21/205

(54) **PROCESS FOR PRODUCING GALLIUM NITRIDE-BASED COMPOUND SEMICONDUCTOR LASER ELEMENT AND GALLIUM NITRIDE-BASED COMPOUND SEMICONDUCTOR LASER ELEMENT**

(30) Priority: 31.03.2005 JP 2005101797
(71) Applicant: SANYO ELECTRIC CO., LTD., Moriguchi-shi, Osaka-fu 570-8677 (JP); Tottori Sanyo Electric Co., Ltd., Tottori-shi, Tottori 680-8634 (JP)
(72) Inventor: MATSUSHITA, Yasuhiko TOTTORI SANYO ELECTRIC CO.LTD, Tottori-shi, Tottori 68068634 (JP); NAKAZAWA, Shuuichi TOTTORI SANYO ELECTRIC CO.,LTD., Tottori-shi, Tottori 6808634 (JP)
(74) Representative: HOFFMANN EITLE
(86) International application number: PCT/JP2006/306848
(87) International publication number: WO 2006/106928

(57) **Abstract**

This invention provides a process for producing a gallium nitride-based compound semiconductor laser element, **characterized in that** a plane inclined at not less than 0.16 degree and not more than 5.0 degrees in terms of absolute value in the direction of <1-100> in (0001) Ga plane, or a plane in which the root mean square of (A² + B²) is not less than 0.17 and not more than 7.0 wherein A represents the off angle of (0001) Ga plane to <1-100> direction and B represents the off angle of (0001) Ga plane to <11-20> direction, is used as a crystal growth plane of a gallium nitride substrate, and an active layer is grown at a growth rate of not less than 0.5 ú/sec and not more than 5.0 ú/sec. The production process is advantageous in that, even in the case of use of a gallium nitride substrate having a large off angle, the slope efficiency is high, the element resistance is reduced, the drive voltage can be reduced, the production yield is high, the variation is small, and high-output violet light can be generated. There is also provided a compound semiconductor laser element produced by the above process.

## Description

### TECHNICAL FIELD

The present invention relates to a process for producing a compound semiconductor laser element and to a compound semiconductor laser element fabricated using this production process, and particularly relates to a process for producing a gallium nitride-based compound semiconductor laser element having a high slope efficiency that allows short wavelength violet light to be emitted and to a gallium nitride-based compound semiconductor laser element fabricated using this production process.

### BACKGROUND ART

In recent years, nitride-based compounds have primarily been used in blue LEDs and violet semiconductor lasers. These nitride-based semiconductors are ordinarily grown on sapphire substrates, SiC substrates, or GaN and other nitride-based semiconductor substrates using MOCVD (Metal Organic Chemical Vapor Deposition), MBE (Molecular Beam Epitaxy), HVPE (Hydride Vapor Phase Epitaxy), or another crystal growth method. Among these, MOCVD is most often used as the crystal growth method.

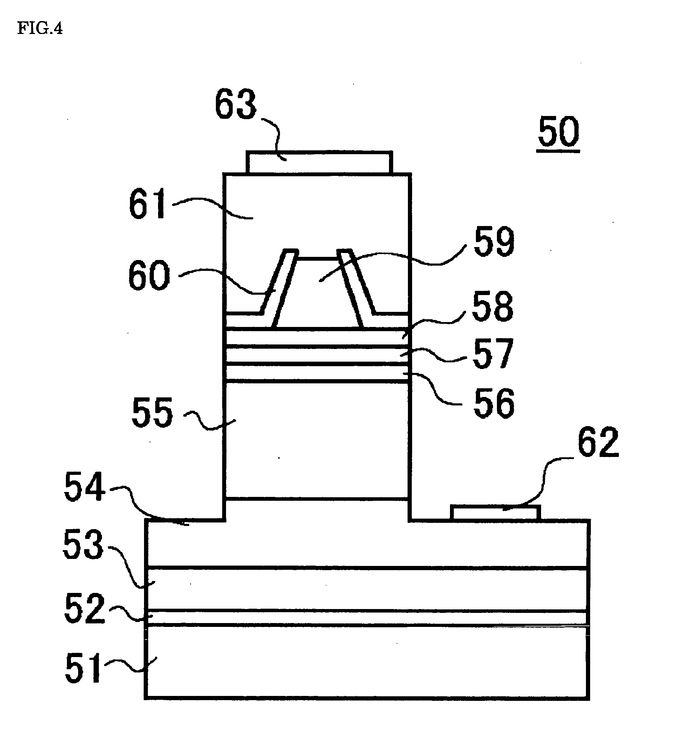

A specific example of a conventional nitride-based semiconductor laser element is shown in FIG. 4. FIG. 4 is a schematic cross-sectional view of a conventional nitride-based semiconductor element 50. This nitride-based semiconductor laser element 50 is composed of a buffer layer 52 on a sapphire substrate 51, an undoped GaN layer 53, an n-GaN contact layer 54, an n-AlGaN cladding layer 55, an n-GaN optical guide layer 56, an active layer 57, and a p-GaN optical guide layer 58, in the stated order. A ridge-shaped p-AlGaN cladding layer 59 is formed in an area having a prescribed width on the p-GaN optical guide layer 58, and a current confinement layer 60 is formed on the side surface of this ridge-shaped p-AlGaN cladding layer 59. A p-GaN contact layer 61 is formed on the upper surface of the p-AIGaN cladding layer 59 and on the current confinement layer 60. A portion of the area from the p-GaN contact layer 61 to the n-GaN contact layer 54 is removed and the n-GaN contact layer 54 is exposed to form a mesa-like shape. An n-electrode 62 is formed on a prescribed area of the exposed n-GaN contact layer 54, and a p-electrode 63 is formed on a prescribed area of the p-GaN contact layer 61.

In a nitride-based semiconductor element composed of a gallium nitride-based semiconductor layer on such a sapphire substrate, the difference of the lattice constants between sapphire substrate and the gallium nitride-based semiconductor layer is considerable. For this reason, the gallium nitride-based semiconductor formed on the sapphire substrate contains many dislocations and the crystallinity is poor. It is therefore difficult to achieve good element characteristics in a nitride-based semiconductor element that uses a sapphire substrate.

In view of the above, patent reference 1 noted below shows that good crystallinity can be obtained when a nitride-based semiconductor layer is formed using an SiC substrate having a slope plane (off plane) in a range of 0.02 degrees to 0.6 degrees with respect to the (0001) Si plane of an SiC crystal as a substrate, and the same results can be obtained even when a gallium nitride substrate is used. Patent reference 2 noted below describes an invention of a nitride-based semiconductor light emitting element in which a substrate that has a slope angle of 0.03 degrees or more and 10 degrees or less from the C plane is used as a gallium nitride substrate. Patent reference 3 noted below shows that a nitride-based semiconductor layer having good crystallinity can be obtained when a substrate having a slope plane of 1 degree or more and 20 degrees or less in a prescribed direction from the (0001) plane is used as a gallium nitride substrate. Patent reference 4 shows that a nitride semiconductor layer having good crystallinity can be obtained even in an InGaN system when a substrate having a slope plane of 15 degrees or more and 60 degrees or less from the (0001) C plane is used as a gallium nitride substrate.
[Patent Reference 1]: Japanese Laid-open Patent Application No. 11-233391
[Patent Reference 2]: Japanese Laid-open Patent Application No. 2000-223743
[Patent Reference 3]: Japanese Laid-open Patent Application No. 2002-16000
[Patent Reference 4]: Japanese Laid-open Patent Application No. 2002-344089

### DISCLOSURE OF THE INVENTION

### [Problems the Invention Is Intended To Solve]

However, even if a nitride-based semiconductor layer having good crystallinity can be obtained in a gallium nitride-based compound semiconductor laser element formed using a substrate having a prescribed slope plane from the (0001) plane of a gallium nitride substrate such as that described above, the slope efficiency of the resulting gallium nitride-based compound semiconductor laser element is poor, there is a drawback in the characteristics of the element, and there are cases in which an element is fabricated that is not suitable for high optical output.

As a result of various experiments in a study as to why a gallium nitride-based compound semiconductor laser element having the low slope efficiency described above is fabricated, the present inventors discovered that a gallium nitride-based compound semiconductor laser element having a low slope efficiency may have a slope angle in which the (0001) Ga plane, which is the crystal growth plane of a gallium nitride substrate, is outside of a prescribed numerical range even if the plane is sloped in a single direction or in two directions. A patent application has already been made in Japanese Laid-open Patent Application No. 2005-023322 (hereinafter referred to as "prior application") in relation to a gallium nitride-based compound semiconductor laser element having a high slope efficiency limited to this slope angle.

Specifically, the specification and drawings of the prior application point out that the off-angle of a gallium nitride substrate surface that can be used to produce a gallium nitride-based compound semiconductor laser element having a high slope efficiency is limited, and the slope efficiency decreases when a gallium nitride-based compound semiconductor laser element is fabricated on a substrate having a large off-angle that is beyond the limited off-angle range.

It is known that other advantages are obtained in that element resistance and drive voltage can be reduced when a gallium nitride-based compound semiconductor laser element is formed on the surface of a gallium nitride substrate having a large off-angle. However, a substrate having a large off-angle has conventionally not been used as a gallium nitride-based compound semiconductor laser element because an element that can satisfy slope efficiency as well as achieve such advantages could not be obtained.

As a result of various experiments in a study as to why a gallium nitride-based compound semiconductor laser element having the low slope efficiency described above is fabricated when a gallium nitride substrate having a large off-angle such as that described above is used, the present inventors perfected the present invention having discovered that the slope efficiency is determined by the growth rate of the active layer of the gallium nitride-based compound semiconductor laser element formed on a gallium nitride substrate having a large off-angle area.

Specifically, an object of the present invention is to solve the problems of prior art in that a gallium nitride-based compound semiconductor laser element having a low slope efficiency is obtained when a gallium nitride-based compound semiconductor laser element is fabricated on a gallium nitride substrate having a large off-angle, and to provide a process for producing a gallium nitride-based compound semiconductor laser element and a gallium nitride-based compound semiconductor laser element in which the slope efficiency is high, the element resistance is low, the drive voltage can be reduced, the production yield is high, variation is small, and high-output violet light can be generated, even when a gallium nitride substrate is having a large off-angle is used.

### [Means for Solving the Abovementioned Problems]

The above-described objects of the present invention can be achieved by the configuration described below. The invention of the process for producing a gallium nitride-based compound semiconductor laser element according to claim 1 is a process for producing a gallium nitride-based compound semiconductor laser element on a gallium nitride substrate, wherein the process is characterized in using a plane inclined at not less than 0.16 degrees and not more than 5.0 degrees in terms of the absolute value in the direction of <1-100> in the (0001) Ga plane as a crystal growth plane of the gallium nitride substrate; and growing an active layer at a growth rate of 0.5 Å/sec or more and 5.0 Å/sec or less.

In this case, the slope efficiency of an uncoated gallium nitride-based compound semiconductor laser element may not even reach 0.3 W/A when the growth rate of the active layer is less than 0.5 Å/sec for the case that the slope of the crystal growth surface of a gallium nitride substrate is 0.16 degrees or more in terms of the absolute value in the <1-100> direction of the (0001) Ga plane, and the slope efficiency is 0.6 W/A or higher when growth rate of the active layer is 0.5 Å/sec or more. However, if the growth rate of the active layer is too high, the reliability of the element is reduced because the crystal quality of the MQW active layer is reduced. Therefore, the upper limit of the growth rate of the active layer must be kept at 5.0 Å/sec. Also, an undesirable situation occurs when the upper limit of the slope angle is greater than 5 degrees in that the In atoms no longer adequately enter into the MQW active layer and the emission wavelength falls to 395 nm or less.

A gallium nitride-based compound semiconductor laser element having a slope efficiency of 0.6 W/A or higher can be stably obtained by combining the growth rate of the active layer and slope angle range of the crystal growth plane of such a gallium nitride substrate. The reason such a result can be obtained is not currently understood and further research is required. However, the following reasons are possible.

The following have conventionally been hypothesized to be the reasons that the slope efficiency of a laser element is reduced when a substrate plane having a large off-angle is used. In ordinary circumstances, slope efficiency is primarily determined by the magnitude of the luminous efficiency of the active layer, but in the case of an InGaN active layer, a phenomenon occurs in the growth layer whereby the In composition becomes localized under island growth conditions. As a result, an active layer having high luminous efficiency is obtained. Nevertheless, when the growth rate of the active layer is reduced in a conventional manner and the active layer is grown on a substrate plane having a large off-angle, the effect of the step density of the crystal plane being greater than the large off-angle is more marked, the crystal growth mode becomes a stepped growth, and the growth ceased to be island growth such as that observed on a substrate plane having a large off-angle. For these reasons, only a gallium nitride-based compound semiconductor laser element having low slope efficiency is conventionally obtained on a substrate plane having a large off-angle.

With the present invention, the above-described problems can be improved by increasing the growth rate of the active layer to 0.5 Å/sec or more and 5.0 Å/sec or less. In other words, island growth rather than step growth can be achieved as the crystal growth mode by increasing the growth rate even on a substrate plane having a large absolute value of the off-angle. As a result, it is believed that the localization phenomenon of the In composition occurs within the growth layer, and an active layer having a large luminous efficiency can be obtained.

The invention according to claim 2 is the process for producing a gallium nitride-based compound semiconductor laser element according to claim 1, characterized in that the emission wavelength of the semiconductor laser element is 395 to 405 nm.

The invention according to claim 3 is the process for producing a gallium nitride-based compound semiconductor laser element according to claim 1 or 2, characterized in that a resonator plane of the semiconductor laser element is used as the natural cleavage plane of the crystal.

The invention according to claim 4 is the process for producing a gallium nitride-based compound semiconductor laser element according to any of claims 1 to 3, characterized in adjusting the reflectivity of an exit plane of the resonator plane of the semiconductor laser element to 10 to 30%; and forming an end face coat having a reflectivity of 70% or more on a rear plane of the resonator plane.

The invention according to claim 5 is the process for producing a gallium nitride-based compound semiconductor laser element according to any of claims 1 to 3, characterized in forming an end face coat having a reflectivity of 10% or less on the exit plane of the resonator plane of the semiconductor laser element; and forming an end face coat having a reflectivity of 70% or more on the rear plane of the resonator plane.

The invention of a process for producing a gallium nitride-based compound semiconductor laser element according to claim 6 is a process for producing a gallium nitride-based compound semiconductor laser element on a gallium nitride substrate, wherein the process is characterized in using, as a crystal growth plane of the gallium nitride substrate, a plane in which the square root of (A2 + B2) is 0.17 or more and 7.0 or less, wherein A is the off-angle in the <1-100> direction of the (0001) Ga plane and B is the off-angle in the <11-20> direction of the (0001) Ga plane; and growing an active layer at a growth rate of 0.5 Å/sec or more and 5.0 Å/sec or less.

In this case, the slope efficiency of an uncoated gallium nitride-based compound semiconductor laser element may not even reach 0.3 W/A when the growth rate of the active layer is less than 0.5 Å/sec for the case in which the square root of (A2 + B2) is 0.17 or more and 7.0 or less, and the slope efficiency is 0.6 W/A or higher when growth rate of the active layer is 0.5 Å/sec or more. However, if the growth rate of the active layer is too high, the reliability of the element is reduced because the crystal quality of the MQW active layer is reduced. Therefore, the upper limit of the growth rate of the active layer must be kept at 5.0 Å/sec. Also, an undesirable situation occurs when the square root of (A2 + B2) is greater than 7.0 in that the In atoms no longer adequately enter into the MQW active layer and the emission wavelength falls to 395 nm or less.

The invention according to claim 7 is the process for producing a gallium nitride-based compound semiconductor laser element according to claim 6, characterized in that the emission wavelength of the semiconductor laser element is 395 to 405 nm.

The invention according to claim 8 is the process for producing a gallium nitride-based compound semiconductor laser element according to claim 6 or 7, characterized in that a resonator plane of the semiconductor element is used as a natural cleavage plane of the crystal.

The invention according to claim 9 is the process for producing a gallium nitride-based compound semiconductor laser element according to any of claims 6 to 8, characterized in adjusting the reflectivity of an exit plane of the resonator plane of the semiconductor laser element to 10 to 30%; and forming an end face coat having a reflectivity of 70% or more on a rear plane of the resonator plane.

The invention according to claim 10 is the process for producing a gallium nitride-based compound semiconductor laser element according to any of claims 6 to 8, characterized in forming an end face coat having a reflectivity of 10% or less on the exit plane of the resonator plane of the semiconductor laser element; and forming an end face coat having a reflectivity of 70% or more on the rear plane of the resonator plane.

The invention of the gallium nitride-based compound semiconductor laser element according to claim 11 is a gallium nitride-based compound semiconductor laser element formed on a gallium nitride substrate, wherein the element is characterized in having a plane in which a crystal growth plane of the gallium nitride substrate is inclined at not less than 0.16 degrees and not more than 5.0 degrees in terms of the absolute value in the direction of <1-100> in the (0001) Ga plane; and in that an active layer is grown at a growth rate of 0.5 Å/sec or more and 5.0 Å/sec or less.

The invention of the gallium nitride-based compound semiconductor laser element according to claim 12 is a gallium nitride-based compound semiconductor laser element formed on a gallium nitride substrate, the element characterized in having a plane in which a crystal growth plane of the gallium nitride substrate has a square root of (A2 + B2) of 0.17 or more and 7.0 or less, wherein A is the off-angle in the <1-100> direction of the (0001) Ga plane and B is the off-angle in the <11-20> direction of the (0001) Ga plane; and in that an active layer is grown at a growth rate of 0.5 Å/sec or more and 5.0 Å/sec or less.

### [Effect of the Invention]

By providing the above-described configuration, the present invention has the following excellent effects. Specifically, in accordance with the invention of the process for producing a gallium nitride-based compound semiconductor laser element according to claims 1 and 6, a gallium nitride-based compound semiconductor laser element having a slope efficiency of 0.6 W/A or higher can be stably produced even when variation is considered.

Also, in accordance with the invention according to claims 2 and 7, the effect of the present invention is made more manifest when the emission wavelength is in the violet range of 395 to 405 nm.

In accordance with the invention according to claims 3 and 8, the effect of the present invention is made more commercially beneficial because the production yield of a gallium nitride-based compound laser element is considerably improved by using the resonator plane as the natural cleavage plane of the crystal.

In accordance with the invention according to claims 4 and 9, the effect of the present invention is made more beneficial because noise characteristics can be improved when application is made to optical pickup, by applying the present invention to a semiconductor laser element in which the reflectivity of the exit plane of the resonator plane is adjusted to 10 to 30%, and an end face coat having a reflectivity of 70% or more is formed on the rear plane of the resonator plane.

In accordance with the invention according to claims 5 and 10, the effect of the present invention is made more beneficial because application can be made to cases in which higher optical output is required. This is accomplished by applying the present invention to a semiconductor laser element in which an end face coat having a reflectivity of 10% or less is formed on the exit plane of the resonator plane, and an end face coat having a reflectivity of 70% or more is formed on the rear plane of the resonator plane.

In accordance with the invention according to claims 11 and 12, a gallium nitride-based compound semiconductor laser element having a slope efficiency of 0.6 W/A or higher can be stably obtained in each invention even when variations are considered.

### BRIEF DESCRIPTION OF THE DRAWINGS

FIG. 1 is an enlarged longitudinal sectional view of the gallium nitride-based compound semiconductor laser element of the present invention;
FIG. 2 is a diagram showing the relationship between the active layer growth rate and the slope efficiency in a gallium nitride-based compound semiconductor laser element for the case in which the crystal growth plane of the GaN substrate has a slope angle of 0.30 degrees in the <1-100> direction of the (0001) Ga plane;
FIG. 3 is a diagram showing the relationship between the active layer growth rate and the slope efficiency in a gallium nitride-based compound semiconductor laser element for the case in which the crystal growth plane of the GaN substrate has a square root of (A2 + B2) of 0.30, wherein A is the off-angle in the <1-100> direction of the (0001) Ga plane and B is the off-angle in the <11-20> direction of the (0001) Ga plane; and
FIG. 4 is an enlarged longitudinal sectional view of a conventional gallium nitride-based compound semiconductor laser element.

### [Key to Symbols]

- 1: GaN substrate
- 2: n-AlGaN clad layer
- 3: MQV active layer
- 4: InGaN optical guide layer
- 5: AlGaN gap layer
- 6: p-AlGaN clad layer
- 7: p-GaN contact layer
- 8: p-electrode
- 9: pad electrode
- 10: SiO2 film
- 11: n-electrode

### BEST MODE FOR CARRYING OUT THE INVENTION

The best mode for carrying out the present invention will be described in detail below using examples and drawings, however, the examples describe hereinafter are examples of a process for producing a gallium nitride-based compound semiconductor laser element and a gallium nitride-based compound semiconductor laser element fabricated using this production process, and these examples are used to specifically describe the technical concepts of the present invention. The present invention is not limited by these examples, and equivalent application can be made to various modifications that do not depart from the technical concepts described in the claims of the present invention.

### [Experiment 1] (Examples 1 to 3 and comparative examples 1 to 3)

A substrate having an off-angle of 0.30 degrees in the <1-100> direction of the (0001) Ga plane was used as the crystal growth plane of a GaN substrate, semiconductor layers were layered on the substrate in the manner described below to study the relationship between the growth rate of the active layer and the slope efficiency by fabricating six types of gallium nitride-based compound semiconductor laser elements in which the growth rate of the active layer was 0.20 Å/sec (comparative example 1), 0.30 Å/sec (comparative example 2), 0.40 Å/sec (comparative example 3), 0.50 Å/sec (example 1), 0.70 Å/sec (example 2), and 1.00 Å/sec (example 3).

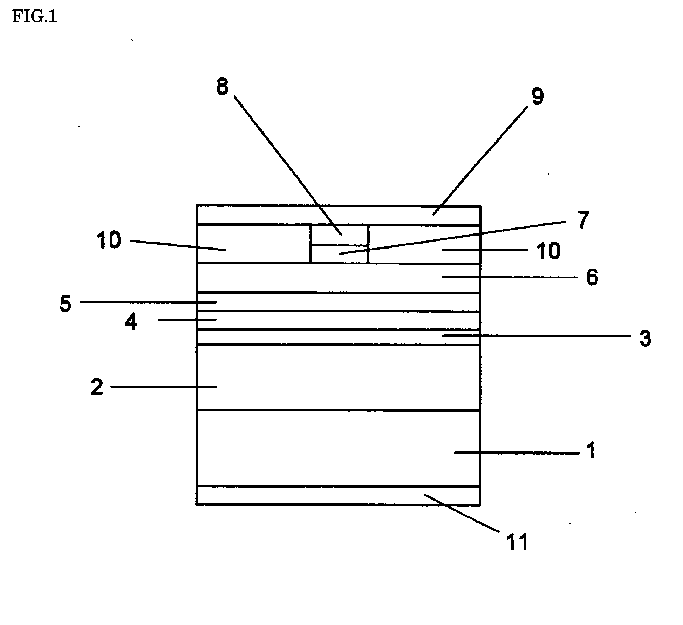

First, an n-AlGaN clad layer (2) was grown on a GaN substrate (1) to a thickness of the 1.0 µm at a growth rate of 3.0 Å/sec using NH3, trimethyl gallium, trimethyl aluminum, and GeH4 as materials at a growing temperature of 1,100°C using the MOCVD method (Metal Organic Chemical Vapor Deposition), as shown in FIG. 1.

The temperature was thereafter reduced, an InGaN well layer of a three-period MQW active layer (3) was grown to a thickness of the 0.003 µm using NH3, trimethyl gallium, and trimethyl indium as materials at a growing temperature of 800°C, and a GaN barrier layer of the MQW active layer (3) was subsequently grown to a thickness of 0.02 µm using NH3 and trimethyl potassium as materials. The growth rates of the MQW active layer described above corresponded to the growth rates of the active layers described in the present invention, and the growth rates were made to correspond to comparative examples 1 to 3 and examples 1 to 3. An InGaN optical guide layer (4) was furthermore grown to a thickness of 0.1 µm using NH3, trimethyl gallium, and trimethyl indium as materials at a growing temperature of 800°C.

An AlGaN gap layer (5) was grown to a thickness of 0.02 µm using trimethyl gallium and trimethyl aluminum as materials at a growing temperature of 800°C. Next, the temperature was increased and a p-AlGaN clad layer (6) was grown to a thickness of the 0.5 µm at a growth rate of 3.0 Å/sec using NH3, trimethyl gallium, trimethyl aluminum, and cylcopentadienyl magnesium as materials at a growing temperature of 1,100°C. Lastly, a p-GaN contact layer (7) was grown to a thickness of the 0.005 µm using NH3, trimethyl gallium, and cylcopentadienyl magnesium as materials at a growing temperature of 1,100°C.

Next, an electrode process was carried out in the following sequence. First, a p-electrode (8) composed of Pt/Pd was formed, ridges (7 and 8), which are current confinement portions, were thereafter formed by dry etching, and a Si02 film (10) was subsequently formed on both sides of the ridges using a CVD apparatus. Next, a pad electrode (9) composed of TVPd/Au was formed, the reverse side of the substrate was polished to give the wafer a thickness of about 110 µm, and an n-electrode (11) composed of A)/Pt/Au was lastly formed to complete the wafer. Following the above process, the element was separated using a scribe step and the gallium nitride-based compound semiconductor laser element shown in FIG. 1 was completed.

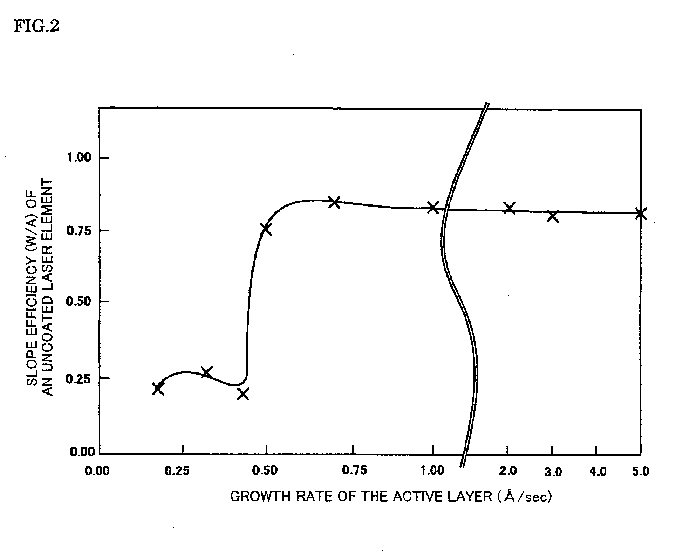

The characteristics of the completed six types of gallium nitride-based compound semiconductor laser elements were evaluated in groups of 10 in an uncoated state at room temperature and the mean values were calculated. The results are shown in FIG. 2 as a relationship between the growth rate of the active layer and the slope efficiency (W/A) of the uncoated laser element, and the respective emission wavelengths are summarized in TABLE 1.

**[TABLE 1]**

| | Active layer growth rate (Å/sec) | Emission wavelength (nm) |
|---|---|---|
| Comparative Ex. 1 | 0.20 | 405 |
| Comparative Ex. 2 | 0.30 | 408 |
| Comparative Ex. 3 | 0.40 | 403 |
| Example 1 | 0.50 | 406 |
| Example 2 | 0.70 | 408 |
| Example 3 | 1.00 | 411 |
| Comparative Ex. 7 | 0.40 | 398 |
| Example 7 | 1.00 | 407 |

According to the results shown in FIG. 2, it is apparent that the slope efficiency is 0.75 W/A or more when the growth rate of the active layer is 0.5 Å/sec or more for the case in which a substrate is used in which the absolute value of the angle sloped in the <1-100> direction of the (0001) Ga plane is 0.30 degrees. A slope efficiency of 0.8 W/A or higher can be expected when the growth rate of the active layer is 0.7 Å/sec or more. Since the reliability of the element is reduced because the growth rate of the active layer is too high and the crystal quality of the MQW active layer is worsened, the upper limit of the growth rate of the active layer must be kept to 5.0 Å/sec. Also, an undesirable situation occurs when the upper limit of the slope angle is greater than 5 degrees in that the In atoms no longer adequately enter into the MQW active layer and the emission wavelength falls to 395 nm or less.

### [Experiment 2] (Examples 4 to 6 and comparative examples 4 to 6)

Next, a substrate having a square root of (A2 + B2) of 0.30 was used as the crystal growth plane of a GaN substrate, wherein A is the off-angle in the <1-100> direction of the (0001) Ga plane and B is the off-angle in the <11-20> direction of the (0001) Ga plane. Six types of gallium nitride-based compound semiconductor laser elements were fabricated in which the growth rate of the active layer was 0.20 Å/sec (comparative example 4), 0.30 Å/sec (comparative example 5), 0.40 Å/sec (comparative example 6), 0.50 Å/sec (example 4), 0.70 Å/sec (example 5), and 1.00 Å/sec (example 6).

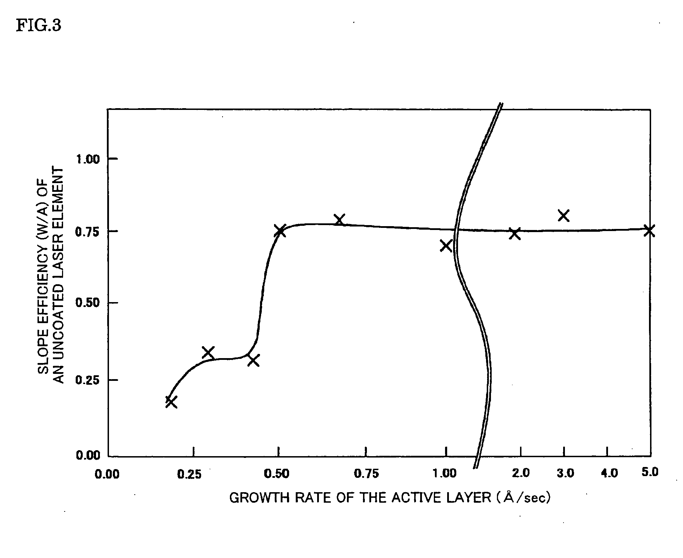

The characteristics of the completed six types of gallium nitride-based compound semiconductor laser elements were evaluated in groups of 10 in an uncoated state at room temperature and the mean values were calculated. The results are shown in FIG. 3 as a relationship between the growth rate of the active layer and the slope efficiency (W/A) of the uncoated laser element in a gallium nitride-based compound semiconductor laser element for the case in which the square root of (A2 + B2) is 0.30, wherein A is the off-angle in the <1-100> direction of the (0001) Ga plane and B is the off angle in the <11-20> direction of the (0001) Ga plane. The respective emission wavelengths are summarized in TABLE 2.

**[TABLE 2]**

| | Active layer growth rate (Å/sec) | Emission wavelength (nm) |
|---|---|---|
| Comparative Ex. 4 | 0.20 | 404 |
| Comparative Ex. 5 | 0.30 | 407 |
| Comparative Ex. 6 | 0.40 | 408 |
| Example 4 | 0.50 | 412 |
| Example 5 | 0.70 | 406 |
| Example 6 | 1.00 | 405 |
| Comparative Ex. 8 | 0.40 | 399 |
| Example 8 | 1.00 | 409 |

According to the results shown in FIG. 3, it is apparent that the slope efficiency is 0.70 W/A or more when the growth rate of the active layer is 0.5 Å/sec or more for the case in which a substrate is used in which the square root of (A2 + B2) is 0.30. A slope efficiency of 0.75 W/A or higher can be expected when the growth rate of the active layer is 0.5 to 0.90 Å/sec or more. However, about the same slope efficiency is obtained up to 5.0 Å/sec within a range of variation in FIG. 3. Since the reliability of the element is reduced because the growth rate of the active layer is too high and the crystal quality of the MQW active layer is worsened, the upper limit of the growth rate of the active layer must be kept to 5.0 Å/sec. Also, an undesirable situation occurs when the square root of (A2 + B2) exceeds 7.0 in that the In atoms no longer adequately enter into the MQW active layer and the emission wavelength falls to 395 nm or less.

### [Example 7 and comparative example 7]

In example 7 and comparative example 7, a substrate having a slope angle of 0.30 degrees in the <1-100> direction of the (0001) Ga plane was used as the crystal growth plane of a GaN substrate. Two types of gallium nitride-based compound semiconductor laser elements were fabricated by layering the semiconductor layers in the same manner as experiment 1 so that the growth rate of the active layer on the substrate was 1.0 Å/sec (example 7) and 0.4 Å/sec (comparative example 7). Using the mean value of 10 elements, the slope efficiency and emission wavelength were 0.8 W/A and 407 nm for the gallium nitride-based compound semiconductor laser element of example 7, and were 0.2 W/A and 398 nm for comparative example 7. The emission wavelengths of the gallium nitride-based compound semiconductor laser elements of example 7 and comparative example 7 are summarized in TABLE 1 to provide a comparison with other examples.

### [Example 8 and comparative example 8]

In example 8 and comparative example 8, a substrate in which A = 0.25, B = 0.17, and the mean square root of (A2 + B2) is 0.30 was used as the crystal growth plane of a GaN substrate, wherein A is the off-angle in the <1-100> direction of the (0001) Ga plane and B is the off-angle in the <11-20> direction of the (0001) Ga plane. Two types of gallium nitride-based compound semiconductor laser elements were fabricated by layering the semiconductor layers in the same manner as experiment 1 so that the growth rate of the active layer on the substrate was 1.0 Å/sec (example 8) and 0.4 Å/sec (comparative example 8). Using the mean value of 10 elements, the slope efficiency and emission wavelength were 0.7 W/A and 409 nm for the gallium nitride-based compound semiconductor laser element of example 8, and were 0.3 W/A and 399 nm for comparative example 8. The emission wavelengths of the gallium nitride-based compound semiconductor laser elements of example 8 and comparative example 8 are summarized in TABLE 2 to provide a comparison with other examples.

The emission wavelength of the gallium nitride-based compound semiconductor laser element of the present invention may be varied by varying the In composition of the well layer of the MWQ active layer, but the effect is more dramatic when the emission wavelength is 395 to 405 nm.

The effect of the present invention is made more commercially beneficial because the production yield is considerably improved due to the fact that a resonator plane having good specularity is obtained by using the resonator plan as the natural cleavage plane of the crystal.

Noise characteristics can be improved when application is made to optical pickup and the effect of the present invention is made more beneficial because return optical noise that enters from the exterior via the exit plane can be reduced by applying the present invention to a semiconductor laser element in which the reflectivity of the exit plane of the resonator plane is adjusted to 10 to 30%, and an end face coat having a reflectivity of 70% or more is formed on the rear plane of the resonator plane.

The effect of the present invention is made more beneficial because the ratio of light emitted to the exterior can be increased due to the fact that the reflectivity of the exit plane is low and higher output can be obtained by applying the present invention to a semiconductor laser element in which an end face coat having a reflectivity of 10% or less is formed on the exit plane of the resonator plane, and an end face coat having a reflectivity of 70% or more is formed on the rear plane of the resonator plane.

## Claims

1. A process for producing a gallium nitride-based compound semiconductor laser element on a gallium nitride substrate, wherein said process for producing a gallium nitride-based compound semiconductor laser element is **characterized in** using a plane inclined at not less than 0.16 degrees and not more than 5.0 degrees in terms of the absolute value in the direction of <1-100> in the (0001) Ga plane as a crystal growth plane of said gallium nitride substrate; and growing an active layer at a growth rate of 0.5 Å/sec or more and 5.0 Å/sec or less.

2. The process for producing a gallium nitride-based compound semiconductor laser element according to claim 1, **characterized in that** the emission wavelength of said semiconductor laser element is 395 to 405 nm.

3. The process for producing a gallium nitride-based compound semiconductor laser element according to claim 1 or 2, **characterized in that** a resonator plane of said semiconductor laser element is used as the natural cleavage plane of the crystal.

4. The process for producing a gallium nitride-based compound semiconductor laser element according to any of claims 1 to 3, **characterized in** adjusting the reflectivity of an exit plane of the resonator plane of said semiconductor laser element to 10 to 30%; and forming an end face coat having a reflectivity of 70% or more on a rear plane of said resonator plane.

5. The process for producing a gallium nitride-based compound semiconductor laser element according to any of claims 1 to 3, **characterized in** forming an end face coat having a reflectivity of 10% or less on the exit plane of the resonator plane of said semiconductor laser element; and forming an end face coat having a reflectivity of 70% or more on the rear plane of said resonator plane.

6. A process for producing a gallium nitride-based compound semiconductor laser element on a gallium nitride substrate, wherein the process for producing a gallium nitride-based compound semiconductor laser element is **characterized in** using, as a crystal growth plane of said gallium nitride substrate, a plane in which the square root of (A2 + B2) is 0.17 or more and 7.0 or less, wherein A is the off-angle in the <1-100> direction of the (0001) Ga plane and B is the off-angle in the <11-20> direction of the (0001) Ga plane; and growing an active layer at a growth rate of 0.5 Å/sec or more and 5.0 Å/sec or less.

7. The process for producing a gallium nitride-based compound semiconductor laser element according to claim 6, **characterized in that** the emission wavelength of said semiconductor laser element is 395 to 405 nm.

8. The process for producing a gallium nitride-based compound semiconductor laser element according to claim 6 or 7, **characterized in that** a resonator plane of said semiconductor element is used as a natural cleavage plane of the crystal.

9. The process for producing a gallium nitride-based compound semiconductor laser element according to any of claims 6 to 8, **characterized in** adjusting the reflectivity of an exit plane of the resonator plane of said semiconductor laser element to 10 to 30%; and forming an end face coat having a reflectivity of 70% or more on a rear plane of said resonator plane.

10. The process for producing a gallium nitride-based compound semiconductor laser element according to any of claims 6 to 8, **characterized in** forming an end face coat having a reflectivity of 10% or less on the exit plane of the resonator plane of said semiconductor laser element; and forming an end face coat having a reflectivity of 70% or more on the rear plane of said resonator plane.

11. A gallium nitride-based compound semiconductor laser element formed on a gallium nitride substrate, wherein the gallium nitride-based compound semiconductor laser element is **characterized in** having a plane in which a crystal growth plane of said gallium nitride substrate is inclined at not less than 0.16 degrees and not more than 5.0 degrees in terms of the absolute value in the direction of <1-100> in the (0001) Ga plane; and **in that** an active layer is grown at a growth rate of 5 Å/sec or more and 5.0 Å/sec or less.

12. A gallium nitride-based compound semiconductor laser element formed on a gallium nitride substrate, the gallium nitride-based compound semiconductor laser element **characterized in** having a plane in which a crystal growth plane of said gallium nitride substrate has a square root of (A2 + B2) of 0.17 or more and 7.0 or less, wherein A is the off-angle in the <1-100> direction of the (0001) Ga plane and B is the off-angle in the <11-20> direction of the (0001) Ga plane; and **in that** an active layer is grown at a growth rate of 0.5 Å/sec or more and 5.0 Å/sec or less.
